(19) Europäisches Patentamt / European Patent Office / Office européen des brevets

(11) **EP 4 016 493 B1**

(12) **FASCICULE DE BREVET EUROPEEN**

(45) Date de publication et mention de la délivrance du brevet:
**05.07.2023 Bulletin 2023/27**

(21) Numéro de dépôt: **21212397.0**

(22) Date de dépôt: **03.12.2021**

(51) Classification Internationale des Brevets (IPC):
*G08C 23/04* (2006.01)   *H04Q 9/00* (2006.01)
*G01C 15/02* (2006.01)   *H01S 5/042* (2006.01)
*H01S 5/06* (2006.01)   *H01S 5/068* (2006.01)
*H01S 5/0683* (2006.01)   *H04B 10/50* (2013.01)

(52) Classification Coopérative des Brevets (CPC):
**H01S 5/0428; H01S 5/06804; H01S 5/06835; H04B 10/503;** H01S 5/0617; H01S 5/06808

(54) **PROCÉDÉ ET DISPOSITIF DE TRANSMISSION DE SIGNAUX OPTIQUES À PUISSANCE MOYENNE ADAPTÉE À LA TEMPÉRATURE ET AU VIEILLISSEMENT, PROGRAMME INFORMATIQUE ET SUPPORT DE PROGRAMME CORRESPONDANTS**

VERFAHREN UND VORRICHTUNG ZUR ÜBERTRAGUNG VON OPTISCHEN SIGNALEN MIT TEMPERATUR- UND ALTERUNGSANGEPASSTER MITTLERER LEISTUNG, ENTSPRECHENDES COMPUTERPROGRAMM UND ENTSPRECHENDER PROGRAMMSUPPORT

METHOD AND DEVICE FOR OPTICAL SIGNAL TRANSMISSION WITH AVERAGE POWER ADAPTED TO TEMPERATURE AND AGEING, CORRESPONDING COMPUTER PROGRAM AND PROGRAM MEDIUM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2020 FR 2013734**

(43) Date de publication de la demande:
**22.06.2022 Bulletin 2022/25**

(73) Titulaire: **SAGEMCOM BROADBAND SAS
92500 Rueil-Malmaison (FR)**

(72) Inventeur: **JAULIN, Jean-Philippe
92500 RUEIL MALMAISON (FR)**

(74) Mandataire: **Lavialle, Bruno François Stéphane et al
Cabinet Boettcher
5 rue de Vienne
75008 Paris (FR)**

(56) Documents cités:
**EP-A1- 3 276 304    CN-B- 107 045 253
CN-U- 210 922 619**

EP 4 016 493 B1

**Description**

La présente invention concerne la transmission de données et plus particulièrement la transmission de données par signaux optiques.

ARRIERE PLAN DE L'INVENTION

Un système de communication par signaux optiques comprend généralement un dispositif d'émission de signal optique, un dispositif de réception de signal optique, et une fibre optique s'étendant entre le dispositif d'émission et le dispositif de réception.

Le dispositif d'émission comprend généralement une diode laser et un organe amplificateur pilotant en courant la diode laser de manière à moduler le signal laser en fonction d'un signal numérique provenant d'un processeur en charge de mettre les données à transmettre en conformité avec le protocole de communication utilisé pour la transmission. Le signal optique émis par le dispositif d'émission dans la fibre optique comprend une succession de niveaux de puissance en fonction du temps qui forment des symboles dont la valeur numérique dépend de la puissance instantanée prélevée par le dispositif de réception au centre temporel de chaque symbole reçu.

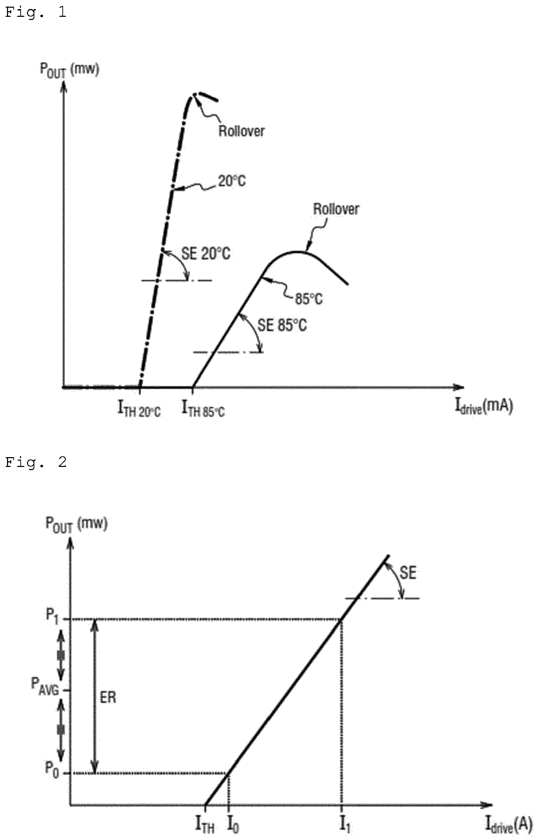

Une diode laser produit un faisceau de puissance lorsque la diode laser est soumise à un courant d'excitation d'intensité supérieure à un seuil laser (Ith). Sur la figure 1 est représentée la puissance $P_{out}$ du faisceau laser produit par une diode laser alimentée par un courant électrique d'excitation ayant une intensité $I_{Drive}$. On peut voir que, lorsque l'intensité $I_{Drive}$ du courant d'excitation dépasse le seuil laser $I_{Th}$, la diode laser produit un faisceau dont la puissance $P_{out}$ augmente quasi-linéairement avec l'intensité du courant d'excitation depuis le seuil laser jusqu'à un point d'inflexion dit « rollover » au-delà duquel la puissance diminue malgré l'augmentation de l'intensité du courant d'excitation. L'efficacité (SE) de la diode laser est la pente de la partie linéaire de la courbe de puissance en fonction de l'intensité du courant d'excitation.

Par ailleurs, il est connu que, pour être exploitable en transmission de signal, un faisceau laser doit avoir une puissance moyenne $P_{avg}$ comprise dans une plage prédéfinie et un taux d'extinction ER (de l'anglais « extinction ratio ») suffisamment grand. Le taux d'extinction vaut $10\log\left(\frac{P1}{P0}\right)$ et est donc représentatif du rapport entre la puissance lumineuse P1, relativement forte, correspondant au niveau logique 1 et la puissance lumineuse P0, relativement faible, correspondant au niveau logique 0 : la différence entre les puissances P1 et P0 à l'émission doit être suffisamment grande pour assurer que le niveau logique 1 pourra être distingué du niveau logique 0 dans le signal optique reçu par le dispositif de réception. La puissance moyenne $P_{avg}$ est la moyenne des puissances des signaux transmis et peut être approchée en calculant la moyenne entre les puissances P1 et P0. La figure 2 représente la puissance $P_{out}$ du signal optique en fonction de l'intensité $I_{Drive}$ du courant d'excitation et fait correspondre à la puissance P1 une intensité I1 du courant d'excitation et à la puissance P0 une intensité I0 du courant d'excitation.

On sait que les caractéristiques de seuil laser et d'efficacité d'une diode laser sont dégradées lorsqu'augmentent la température et le vieillissement de la diode laser : il faut alors un courant d'excitation ayant une intensité plus élevée pour produire le faisceau laser et la puissance de sortie augmente moins rapidement avec l'intensité du courant d'excitation. La figure 1 montre ainsi une courbe de puissance à la température de 20°C et une courbe de puissance à la température de 85°C dont la comparaison montre que, à 85°C, les intensités à appliquer à la diode laser sont supérieures, l'efficacité est moindre et le rollover intervient plus tôt.

Deux modes de gestion de l'électronique de pilotage du courant d'excitation de la diode laser sont connus.

Le premier mode de gestion définit une contrainte de pilotage en fonction de la température. La température de la diode est mesurée périodiquement et la valeur de l'intensité du courant d'excitation à appliquer est recherchée dans un modèle. Ce mode de pilotage est relativement simple et permet de prédéfinir des niveaux d'intensité du courant d'excitation en fonction de la température en tenant compte, d'une part, de la capacité de l'amplificateur à fournir des courants d'intensité élevée et, d'autre part, des rollovers. En revanche, ceci ne tient pas compte du vieillissement de la diode laser ni des différences existant entre la diode laser utilisée et celles ayant servi à la modélisation.

Dans le deuxième mode de pilotage, l'intensité du courant d'excitation est asservie sur la puissance du faisceau. A cette fin, l'électronique de pilotage comprend une photodiode placée au voisinage de la diode laser pour mesurer un rayonnement parasite de la diode laser. Ce rayonnement parasite a une puissance proportionnelle à la puissance du faisceau en sortie de la diode laser et la photodiode est choisie de type PIN pour que le courant qui la traverse soit indépendant de la température de sorte qu'existe une relation linéaire entre le courant traversant la photodiode et la puissance du faisceau en sortie de la diode laser. Les valeurs de consigne sont fixes et ont été déterminées par itérations successives pour chaque dispositif d'émission lors d'une étape de calibration réalisée en usine. Les performances de ce pilotage dépendent des propriétés de la photodiode. Les limites de fonctionnement de ce type de pilotage dépendent également des non-linéarités comme la capacité de l'amplificateur à produire un courant d'excitation correspondant à la puissance souhaitée du faisceau et la variation du point de rollover de la diode laser utilisée en fonction de son vieillissement. Pour remédier à cet inconvénient, il est connu de limiter la puissance souhaitée sur toute la plage de fonctionnement pour éviter d'atteindre une plage de non-linéarité du système d'asservissement. Ceci ne permet cependant pas de maximiser le rapport signal sur bruit.

Les documents EP 3 276 304 A1 et CN 210922619 U décrivent des procédés pour réduire la puissance de fonctionnement de diodes laser lorsque la température interne détectée atteint un seuil de température.

## OBJET DE L'INVENTION

L'invention a notamment pour but de proposer un pilotage de la diode laser permettant la production d'un faisceau laser dont la puissance moyenne soit la plus élevée possible dans toute sa gamme de fonctionnement.

## RESUME DE L'INVENTION

A cet effet, on prévoit, selon l'invention un procédé de transmission de données, comprenant l'étape de piloter un courant d'excitation d'une diode laser d'un dispositif d'émission d'un faisceau laser en asservissant le courant d'excitation sur une puissance du faisceau laser et en modulant le courant d'excitation en fonction des données à transmettre pour coder ces données avec des niveaux de puissance du faisceau laser. Le procédé de transmission comprend l'étape de mesurer une température au voisinage de la diode laser pour mettre en oeuvre :

- un premier mode de fonctionnement jusqu'à un premier seuil de température prédéterminé et dans lequel le courant d'excitation est asservi en utilisant une valeur inférieure nominale de consigne et une valeur supérieure nominale de consigne correspondant respectivement à un niveau bas de puissance et à un niveau haut de puissance de telle manière que le faisceau ait une puissance moyenne et un taux d'extinction optimaux pour la transmission des données ;
- un deuxième mode de fonctionnement lorsque la température dépasse le premier seuil de température et dans lequel le courant d'excitation est asservi sur une valeur inférieure réduite de consigne et une valeur supérieure réduite de consigne correspondant respectivement au niveau bas de puissance et au niveau haut de puissance de telle manière que le faisceau ait une puissance moyenne réduite en conservant un taux d'extinction acceptable pour la transmission des données.

En mode de fonctionnement nominal, les valeurs de consigne sont choisies pour autoriser une transmission de signaux la plus efficace possible en faisant fonctionner la diode laser à une puissance optimale (déterminée par exemple pour être la plus élevée possible pour une durée de vie prédéterminée de la diode laser). Lorsque la température dépasse le seuil de température, on réduit les valeurs de consigne qu'on choisira judicieusement toujours inférieures au point d'inflexion de la courbe de puissance sur la plage de température correspondant au mode de fonctionnement dégradé. Le risque d'apparition d'une non-linéarité que l'asservissement ne saurait gérer est donc limité. On obtient donc un asservissement de la diode laser en puissance qui tient compte de la température pour prévenir une non-linéarité de la boucle d'asservissement. L'invention concerne également un dispositif d'émission d'un faisceau laser pour la transmission de données, comprenant un circuit électronique de traitement pour créer un signal de courant représentatif de données à transmettre, un amplificateur recevant en entrée le signal de courant et fournissant en sortie un courant d'excitation d'une diode laser, un circuit de pilotage de l'amplificateur ayant une première entrée recevant des valeurs de consigne et une deuxième entrée reliée à une photodiode qui est placée au voisinage de la diode laser pour fournir au circuit de pilotage un courant représentatif d'une puissance du faisceau laser, une sonde de température reliée au circuit de traitement pour fournir un signal de température au voisinage de la diode laser ; le circuit de traitement étant agencé pour mettre en oeuvre le procédé de transmission de l'invention.

L'invention a aussi pour objet un programme informatique pour la mise en oeuvre de ce procédé et un support de données contenant un tel programme.

D'autres caractéristiques et avantages de l'invention ressortiront à la lecture de la description qui suit d'un mode de mise en oeuvre particulier et non limitatif de l'invention.

## BREVE DESCRIPTION DES DESSINS

Il sera fait référence aux dessins annexés, parmi lesquels :

[Fig. 1] la figure 1 est une représentation de la puissance du faisceau laser produit par une diode laser alimentée par un courant électrique d'excitation ayant une intensité $I_{Drive}$, pour deux températures différentes° ;
[Fig. 2] la figure 2 est une représentation de la puissance du faisceau laser produit par une diode laser alimentée par un courant électrique d'excitation ayant une intensité $I_{Drive}$, mettant en évidence le taux d'extinction et la puissance moyenne d'un faisceau laser ;

[Fig. 3] la figure 3 est une représentation schématique d'un dispositif d'émission selon l'invention ;

[Fig. 4] la figure 4 est une représentation de la puissance moyenne du faisceau laser en fonction de la température selon un premier mode de mise en oeuvre du procédé selon l'invention° ;

[Fig. 5] la figure 5 est un logigramme illustrant ce premier mode de mise en oeuvre ;

[Fig. 6] la figure 6 est une représentation de la puissance moyenne du faisceau laser en fonction de la température selon un deuxième mode de mise en oeuvre du procédé selon l'invention° ;

[Fig. 7] la figure 7 est un logigramme illustrant ce deuxième mode de mise en oeuvre.

DESCRIPTION DETAILLEE DE L'INVENTION

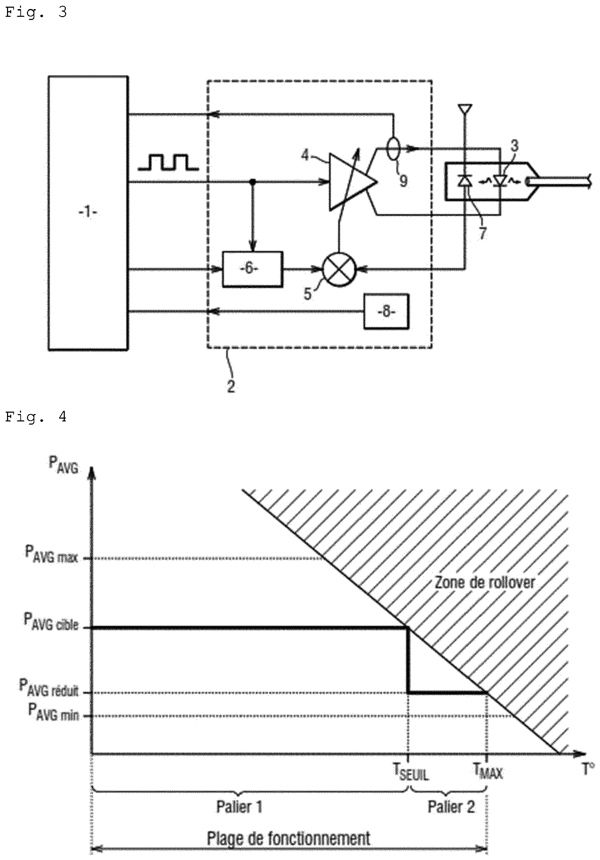

En référence à la figure 3, le dispositif d'émission d'un faisceau laser pour la transmission de données selon des modes de réalisation de l'invention, comprend un circuit électronique de traitement 1 relié via une interface de pilotage 2 à une diode laser 3. Le modèle de diode laser importe peu, mais l'utilisation du composant référencé EBS63432-B1634 produit par la société EZCONN peut par exemple être envisagé.

Le circuit de traitement 1 comprend ici un processeur et une mémoire contenant des programmes informatiques exécutables par le processeur. L'un de ces programmes est agencé de manière connue en elle-même pour assurer le formatage de données à transmettre selon un protocole prédéfini et l'élaboration du signal de courant représentatif des données à transmettre dans le format considéré.

L'interface de pilotage 2 comprend un amplificateur 4 ayant une entrée reliée au circuit de traitement 1 pour recevoir le signal de courant représentatif du niveau logique à transmettre et une sortie reliée à la diode laser 3 à laquelle l'amplificateur 4 fournit un courant d'excitation.

L'amplificateur 4 est de type analogique et a une entrée de pilotage reliée à un circuit électronique numérique d'asservissement 5. Le circuit d'asservissement 5 a :

- une première entrée reliée à une mémoire 6 elle-même reliée au circuit de traitement 1 pour sélectionner les valeurs de consigne à appliquer parmi L0 et L1 en fonction du niveau du signal numérique à transmettre ;
- une deuxième entrée qui est reliée via un convertisseur analogique/numérique non représenté à une photodiode 7 placée au voisinage de la diode laser 3 et qui reçoit un signal $I_{MON}$ représentatif d'une puissance du faisceau laser produit par la diode laser 3. Plus précisément, la photodiode 7 est ici positionnée pour capter un rayonnement lumineux parasite à l'arrière de la diode laser 3, la puissance de ce rayonnement lumineux parasite étant directement liée à la puissance du faisceau lumineux utile produit par la diode laser 3 ;
- une sortie reliée via un convertisseur numérique/analogique non représenté à l'entrée de pilotage de l'amplificateur 4.

L'interface de pilotage 2 comprend une sonde de température 8 placée au voisinage de la diode laser 3 et reliée au circuit de traitement 1 pour lui fournir un signal de température représentatif de la température au voisinage de la diode laser 3.

L'interface de pilotage 2 comprend un organe 9 de mesure du courant d'excitation I0/I1 placé entre l'amplificateur 4 et la diode laser 3 et relié au circuit de traitement 1.

L'interface de pilotage 2 est par exemple celle référencée M02099 produite par la société MACOM permettant la mise en place d'un environnement de communication dénommé G-PON (de l'anglais « Gigabit capable Passive Optical Network » ou réseau optique passif à capacité gigabit).

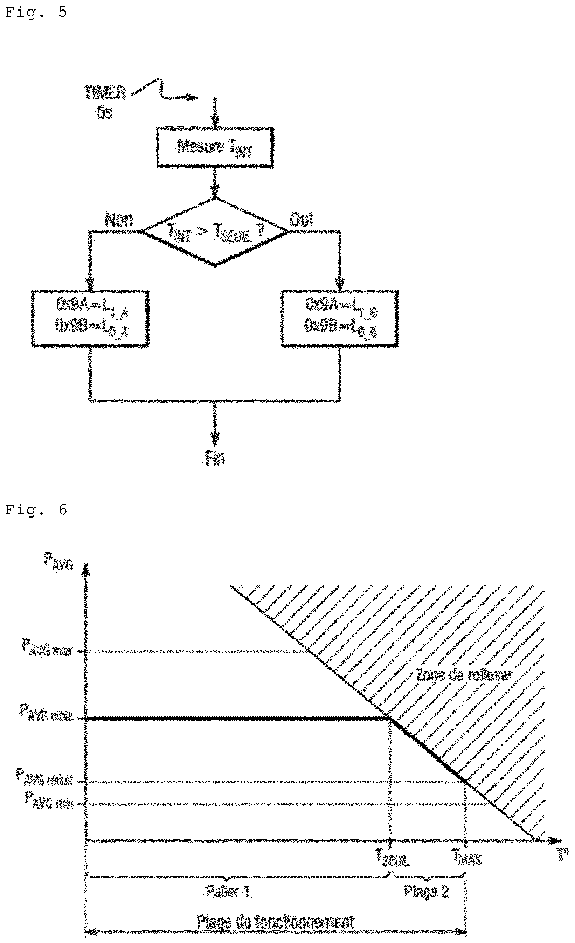

L'environnement G-PON pour sa partie physique est défini par la recommandation ITU-T G.984.2 et on rappelle que les principales caractéristiques pour la transmission dans le sens amont pour ce protocole de communication sont, pour toute la plage de fonctionnement (voir les figures 4 et 6) :

- débit de 1,244 Gbits/s ;
- codage par modulation NRZ tel que le niveau logique 0 est transmis sous la forme d'un signal lumineux de faible puissance et le niveau logique 1 est transmis sous la forme d'un signal lumineux de forte puissance ;
- puissance moyenne $P_{AVG\ min}$ minimale (voir sur les figures 4 et 6) du signal optique lancé : +0,5 dBm ;

- puissance moyenne $P_{AVG\ max}$ maximale (voir sur les figures 4 et 6) du signal optique lancé : +5 dBm ;
- taux d'extinction ER minimal : 10 dB.

La transmission est assurée en modulant le courant d'excitation de la diode laser 3 suivant deux intensités de courant associées au niveaux logiques 0 et 1 à transmettre.

L'un des programmes de l'unité de traitement comprend ainsi des instructions agencées pour mettre en oeuvre un procédé de transmission comprenant l'étape de piloter un courant d'excitation de la diode laser 3 en asservissant le courant d'excitation sur une puissance du faisceau laser produit par la diode laser 3 et en modulant le courant d'excitation en fonction des données à transmettre pour coder ces données avec des niveaux de puissance du faisceau laser. On comprend que, dans l'agencement proposé : les amplificateurs tels que l'amplificateur 4 ont des caractéristiques variables d'un individu à l'autre ; de même, les convertisseurs analogique/numérique et les convertisseurs numérique/analogique ont des caractéristiques variables d'un individu à l'autre ; la première entrée du circuit d'asservissement fournit une valeur numérique ; la deuxième entrée du circuit d'asservissement fournit elle aussi une valeur numérique issue d'un convertisseur analogique/numérique. Il en résulte que toutes ces variables ne permettent pas de maîtriser la relation exacte entre les grandeurs manipulées au sein du circuit d'asservissement, la puissance du faisceau et les courants mis en oeuvre : il est donc d'usage d'utiliser des valeurs de consigne sans unité stricte.

Selon un premier mode de réalisation, le procédé de transmission prévoit de mesurer périodiquement une température $T_{INT}$ au voisinage de la diode laser 3 et de la comparer à un premier seuil de température $T_{SEUIL}$ prédéterminé pour mettre en oeuvre :

- un mode de fonctionnement nominal (palier 1 sur les figures 4 et 6) tant que la température est inférieure ou égale au premier seuil de température $T_{SEUIL}$, dans lequel le courant d'excitation est asservi en utilisant une valeur inférieure nominale de consigne $L_{0\_A}$ et une valeur supérieure nominale de consigne $L_{1\_A}$ correspondant respectivement à un niveau bas de puissance et à un niveau haut de puissance (correspondant respectivement au niveau logique 0 et au niveau logique 1 dans un exemple de mode de réalisation utilisant une modulation de type NRZ) de telle manière que le faisceau ait une puissance moyenne et un taux d'extinction optimaux ;
- un mode de fonctionnement dégradé (palier 2 sur la figure 4 et plage 2 sur la figure 6) lorsque la température dépasse le premier seuil de température $T_{SEUIL}$ et dans lequel le courant d'excitation est asservi sur une valeur inférieure réduite de consigne $L_{0\_B}$ et une valeur supérieure réduite de consigne $L_{1\_B}$ correspondant respectivement au niveau bas de puissance (niveau logique 0 dans une modulation de type NRZ) et au niveau haut de puissance (niveau logique 1 dans une modulation de type NRZ) de telle manière que le faisceau laser ait une puissance moyenne réduite en conservant un taux d'extinction acceptable pour assurer la transmission des données.

La valeur inférieure nominale de consigne $L_{0\_A}$ et la valeur supérieure nominale de consigne $L_{1\_A}$ sont enregistrées dans la mémoire du circuit de traitement 1. Elles ont été définies lors d'une étape de calibration pour obtenir une puissance moyenne cible $P_{AVG\ cible}$ correspondant à un pourcentage de la puissance moyenne maximale $P_{AVG\ max}$ que la diode laser 3 est capable de fournir, par exemple 70% (voir les figures 4 et 6) et pour obtenir le taux minimal d'extinction souhaité à savoir 10 dB.

L'étape de calibration est connue en elle-même : elle est réalisée en usine, par itérations successives, et consiste à fixer des valeurs de consigne et à laisser l'asservissement fonctionner jusqu'à ce qu'il converge et atteigne un point d'équilibre. Les valeurs de consigne retenues sont celles ayant permis, après convergence, d'obtenir les propriétés souhaitées du faisceau laser. Alternativement, les valeurs nominales de consigne $L_{0\_A}$ et $L_{1\_A}$ sont choisies en fonction des caractéristiques connues du dispositif d'émission. Dans un exemple, une phase de calibration est opérée sur un dispositif d'émission référence afin de déterminer les valeurs nominales de consigne $L_{0\_A}$ et $L_{1\_A}$ pour d'autres dispositifs d'émission. Dans un autre exemple, les valeurs nominales de consigne $L_{0\_A}$ et $L_{1\_A}$ sont choisies en fonction des caractéristiques de certains éléments constitutifs du dispositif d'émission.

Dans le premier mode de mise en oeuvre illustré par les figures 4 et 5, la valeur inférieure réduite de consigne $L_{0\_B}$ et la valeur supérieure réduite de consigne $L_{1\_B}$ sont des valeurs fixes.

Selon un premier exemple, la valeur inférieure réduite de consigne $L_{0\_B}$ et la valeur supérieure réduite de consigne $L_{1\_B}$ sont déterminées expérimentalement à partir d'essais réalisés sur un échantillon de dispositifs d'émission de signaux en laissant converger le mode de fonctionnement dégradé de chaque dispositif d'émission vers une valeur supérieure réduite issue de convergence et une valeur inférieure réduite issue de convergence.

Plus précisément, la valeur inférieure réduite de consigne $L_{0\_B}$ et la valeur supérieure réduite de consigne $L_{1\_B}$ sont définies pour être égales à l'une des valeurs suivantes, respectivement :

- une moyenne des valeurs inférieures réduites issues de convergence et une moyenne des valeurs supérieures réduites issues de convergence pour tout l'échantillon ;
- un minimum des valeurs inférieures réduites issues de convergence et un minimum des valeurs supérieures réduites issues de convergence pour tout l'échantillon ;
- un vingt-cinquième percentile des valeurs inférieures réduites issues de convergence et un vingt-cinquième percentile des valeurs supérieures réduites issues de convergence pour tout l'échantillon.

Selon un deuxième exemple, la valeur inférieure réduite de consigne $L_{0\_B}$ et la valeur supérieure réduite de consigne $L_{1\_B}$ sont déterminées par calcul à partir respectivement de la valeur inférieure nominale de consigne $L_{0\_A}$ et la valeur supérieure nominale de consigne $L_{1\_A}$.

Ainsi, la valeur inférieure réduite de consigne $L_{0\_B}$ et la valeur supérieure réduite de consigne $L_{1\_B}$ sont déterminées en appliquant, respectivement à la valeur inférieure nominale de consigne $L_{0\_A}$ et à la valeur supérieure nominale de consigne $L_{1\_A}$, une dépréciation comprise avantageusement entre 30% et 40%, de préférence 37% pour abaisser la puissance moyenne transmise d'environ 2 dB en conservant sensiblement le même taux d'extinction. Ainsi, avec l'environnement G-PON, si on fixe la puissance moyenne à 2,5 dB sur le palier 1 correspondant au mode de fonctionnement nominal, on obtient une puissance moyenne de 0,5 dB sur le palier 2 correspondant au mode de fonctionnement dégradé, ce qui reste conforme à la recommandation ITU-T G.984.2.

Dans tous les cas, on s'assure que la puissance moyenne du faisceau est supérieure à la puissance moyenne minimale de manière suffisante pour permettre l'obtention d'un taux d'extinction supérieur à 10 dB dans le présent exemple. La puissance moyenne retenue pour correspondre au niveau inférieur est avantageusement déterminée pour être supérieure à la puissance moyenne minimale de manière à permettre une meilleure réception. Grâce aux valeurs de consigne réduites, cette puissance moyenne réduite peut être atteinte sans utiliser une intensité supérieure à celle correspondant au point d'inflexion de la courbe de puissance (on a hachuré sur la figure 4 toute la zone, dite zone de rollover, correspondant aux puissances inatteignables, malgré l'augmentation du courant d'excitation, du fait de l'inflexion de la courbe de puissance).

Le premier seuil de température $T_{SEUIL}$ est situé en regard de l'intersection entre la courbe de puissance moyenne cible $P_{AVG\,cible}$ en mode de fonctionnement nominal et la limite de la zone de rollover.

La valeur inférieure réduite de consigne $L_{0\_B}$ et la valeur supérieure réduite de consigne $L_{1\_B}$ sont enregistrées dans la mémoire du circuit de traitement 1.

En fonctionnement (voir la figure 5), le circuit de traitement 1 acquiert toutes les 5 secondes la mesure de température $T_{INT}$ et la compare au premier seuil de température $T_{SEUIL}$.

Si la température $T_{INT}$ est inférieure au premier seuil de température $T_{SEUIL}$, le circuit de traitement 1 déclenche le mode nominal en écrivant la valeur nominale inférieure de consigne $L_{0\_A}$ et la valeur nominale supérieure de consigne $L_{1\_A}$ dans des registres de la mémoire 6 (par exemple, respectivement le registre à l'adresse 0x9A et le registre à l'adresse 0x9B de la mémoire 6 du composant MACOM M02099) où le circuit d'asservissement 5 va les chercher pour piloter l'amplificateur 4 de manière à asservir le courant d'excitation entre ces deux valeurs en fonction du signal $I_{MON}$ représentatif de la puissance du faisceau laser.

Si la température $T_{INT}$ est supérieure au premier seuil de température $T_{SEUIL}$, le circuit de traitement 1 déclenche le mode de fonctionnement dégradé en écrivant la valeur inférieure réduite de consigne $L_{0\_B}$ et la valeur supérieure réduite de consigne $L_{1\_B}$ dans les registres de la mémoire 6 (par exemple les registres aux adresses 0x9A et 0x9B) où le circuit d'asservissement 5 va les chercher pour piloter l'amplificateur 4 de manière à asservir le courant d'excitation entre ces deux valeurs en fonction du signal $I_{MON}$ représentatif de la puissance du faisceau laser.

Pour éviter de réécrire toutes les 5 secondes les valeurs de consigne dans la mémoire 6, il est possible de prévoir que :

- le circuit de traitement 1 enregistre dans sa mémoire les dernières valeurs qu'il a écrites dans la mémoire 6 ;
- après avoir déterminé des valeurs de consigne qui doivent être appliquées, comparer ces valeurs de consigne qui doivent être appliquées aux valeurs de consigne dernièrement écrites en mémoire ;
- seulement si ces valeurs de consigne qui doivent être appliquées sont différentes des valeurs de consigne dernièrement écrites en mémoire, procéder à l'écriture dans la mémoire 6 des valeurs de consigne qui doivent être appliquées.

Afin d'éviter des allers et retours rapides d'un mode de fonctionnement à l'autre, le circuit de traitement 1 passe du mode de fonctionnement nominal au mode de fonctionnement dégradé quand la température $T_{INT}$ au voisinage de la diode laser 3 dépasse le premier seuil de température $T_{SEUIL}$ d'une valeur de dépassement prédéterminée et passe du mode de fonctionnement dégradé au mode de fonctionnement nominal quand la température $T_{INT}$ au voisinage de la diode laser 3 passe en dessous du premier seuil de température $T_{SEUIL}$ diminué d'une valeur de retour prédéterminée. La valeur de dépassement et la valeur de retour sont ici égales à 3°C.

Dans ce mode de mise en oeuvre, il est prévu un deuxième seuil de température $T_{MAX}$, ou seuil limite, supérieur au premier seuil de température $T_{SEUIL}$.

Le deuxième seuil de température $T_{MAX}$ est situé en regard de l'intersection entre la courbe de puissance moyenne réduite $P_{AVG\,réduite}$ en mode de fonctionnement dégradé et la limite de la zone de rollover.

Le circuit de traitement 1 compare toutes les 5 secondes la mesure de température $T_{INT}$ et le deuxième seuil de température $T_{MAX}$. Si la mesure de température $T_{INT}$ dépasse le deuxième seuil de température $T_{MAX}$, le circuit de traitement 1 coupe l'alimentation de l'amplificateur 4 de sorte que la diode laser 3 n'est plus alimentée permettant son refroidissement et évitant un vieillissement prématuré. Le circuit de traitement 1 peut émettre alors une alerte renvoyant un message d'erreur vers l'unité émettrice des données raccordée au circuit de traitement 1.

En variante, on peut également prévoir, en cas de franchissement du deuxième seuil de température $T_{MAX}$, de réduire encore les valeurs réduites de consigne pour limiter la puissance du faisceau laser mais en prenant le risque d'une transmission imparfaite des signaux.

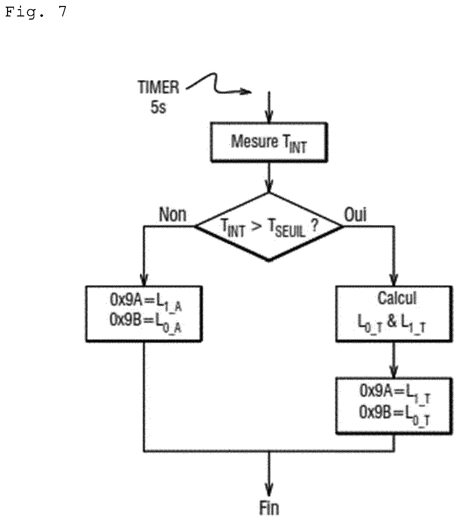

Dans le deuxième mode de mise en oeuvre illustré par les figures 6 et 7, on utilise la valeur inférieure réduite de consigne $L_{0\_B}$ et la valeur supérieure réduite de consigne $L_{1\_B}$, déterminées comme dans le premier mode de mise en oeuvre, mais en tant que des valeurs réduites théoriques de consigne.

Ces valeurs théoriques de consignes vont être utilisées dans le calcul d'une valeur inférieure réduite de consigne $L_{0\_T}$ utilisée pour l'asservissement et d'une valeur supérieure réduite de consigne $L_{1\_T}$ utilisée pour l'asservissement. Le calcul est réalisé lors du fonctionnement du dispositif d'émission et est une interpolation linéaire à partir des valeurs nominales de consigne $L_{0\_A}$, $L_{1\_A}$, des valeurs réduites théoriques de consigne $L_{0\_B}$, $L_{1\_B}$, de la température déterminée $T_{INT}$, du premier seuil de température $T_{SEUIL}$, du deuxième seuil de température $T_{MAX}$ de sorte que :

- la valeur inférieure réduite de consigne $L_{0\_T}$ utilisée pour l'asservissement est égale à

$$L_{0\_T} = L_{0\_A} + (T_{INT} - T_{SEUIL}) \frac{L_{0\_B} - L_{0\_A}}{T_{MAX} - T_{SEUIL}}$$

- la valeur supérieure réduite de consigne $L_{1\_T}$ utilisée pour l'asservissement est égale à

$$L_{1\_T} = L_{1\_A} + (T_{INT} - T_{SEUIL}) \frac{L_{1\_B} - L_{1\_A}}{T_{MAX} - T_{SEUIL}}$$

Contrairement au premier mode de mise en oeuvre dans lequel la courbe de puissance moyenne formait une marche entre le premier palier (droite horizontale pour le palier 1 sur la figure 4) et le deuxième palier (droite horizontale pour le palier 2 sur la figure 4), la courbe de puissance moyenne présente une pente descendante au niveau de la plage de température correspondant au mode de fonctionnement dégradé (plage 2 sur la figure 5). Cette pente descendante est confondue avec la limite de la zone de rollover entre les seuils de température $T_{SEUIL}$ et $T_{MAX}$.

Le fonctionnement est illustré sur la figure 7 : il est identique à celui du premier mode de mise en oeuvre sauf en ce que le circuit de traitement 1 doit calculer la valeur inférieure réduite de consigne $L_{0\_T}$ utilisée pour l'asservissement et la valeur supérieure réduite de consigne $L_{1\_T}$ utilisée pour l'asservissement juste avant de les inscrire dans la mémoire 6 pour initier le mode fonctionnement dégradé.

Bien entendu, l'invention n'est pas limitée aux modes de réalisation décrits mais englobe toute variante entrant dans le champ de l'invention telle que définie par les revendications.

En particulier, tout ou partie des modes de réalisation peuvent aisément être adaptés pour couvrir d'autres protocoles de communication, tels que ceux nommés E-PON, XGS-PON, 10GEPON... ou encore d'autres modèles de composants de pilotage issus de la société MACOM ou d'autres sociétés telles que par exemple SEMTECH ou UXFASTIC.

Dans l'exemple décrit, on utilise la modulation NRZ selon laquelle le signal optique lancé prend deux puissances selon qu'il transporte un 0 ou un 1 est généralement utilisé. Elle permet donc le transport d'un bit par temps symbole est bien adaptée à des débits jusqu'à 25 Gbits/s. Néanmoins d'autres modulations sont utilisables pour ces mêmes débits ou d'autres. Par exemple, au-delà de 25 Gbits/s, on utilisera la modulation PAM4 qui permet le transport de deux bits par temps symbole, le signal optique lancé prenant quatre puissances selon qu'il transporte un symbole 00, 01, 10 ou 11. Plus généralement, dans certains modes de réalisation, on peut utiliser n'importe quel protocole de communication reposant sur une technique de transmission avec plusieurs niveaux logiques, telle que par exemple les dérivés de la modulation d'impulsions en amplitude (PAM pour l'anglais « Pulse-amplitude modulation PAM »).

Dans l'exemple décrit, la transmission d'un niveau logique 0 est établie en lançant dans la fibre optique un signal lumineux de faible puissance (quelques centaines de $\mu$W) et la transmission d'un niveau logique 1 est établie en lançant dans la fibre optique un signal lumineux de plus forte puissance (quelques mW). Bien entendu, l'inverse peut être prévu.

En variante, il est possible de se passer du deuxième seuil de température. Dans le deuxième mode de mise en oeuvre, cela revient à laisser l'interpolation se poursuivre au-delà de la température correspondant au deuxième seuil, ce qui n'est pas problématique pour la diode laser qui sera préservée du fait de la diminution de la puissance moyenne mais va limiter la capacité de transmission des données.

Il est possible de combiner les deux modes de mises en oeuvre décrit ci-dessus. Ceci n'est pas obligatoire et, dans le deuxième mode de réalisation, le calcul de la valeur inférieure réduite de consigne $L_{0\_T}$ utilisée pour l'asservissement et de la valeur supérieure réduite de consigne $L_{1\_T}$ utilisée pour l'asservissement peut être différent.

Les valeurs réduites de consigne L$_{0\_B}$, L$_{1\_B}$ peuvent être déterminées par itérations successives lors d'une phase de calibration.

Lorsque les valeurs réduites sont déterminées par calcul, il est avantageux que la température T$_{INT}$ au voisinage de la diode laser soit déterminée selon une période prédéterminée et les valeurs réduites de consigne L$_{0\_B}$, L$_{1\_B}$ soient calculées selon cette période.

La diode laser est pilotée pour avoir, dans le troisième mode de fonctionnement (la température dépasse le deuxième seuil de température T$_{MAX}$ prédéterminé), un fonctionnement encore plus limité qu'en deuxième mode de fonctionnement. La période de mesure de température peut être inférieure ou supérieure à 5 seconde.

Les seuils de températures, valeur de dépassement et valeur de retour peuvent être différents de ceux décrits. Le deuxième seuil de température est facultatif.

La structure du dispositif peut être différente. La sonde de température peut être hors de l'interface de pilotage 2.

L'organe de mesure 9 est facultatif.

## Revendications

1.    Procédé de transmission de données, comprenant l'étape de piloter un courant d'excitation d'une diode laser d'un dispositif d'émission d'un faisceau laser en asservissant le courant d'excitation sur une puissance du faisceau laser et en modulant le courant d'excitation en fonction des données à transmettre pour coder ces données avec des niveaux de puissance du faisceau laser, **caractérisé en ce que** le procédé de transmission comprend l'étape de mesurer une température (T$_{INT}$) au voisinage de la diode laser pour mettre en oeuvre :

- un premier mode de fonctionnement jusqu'à un premier seuil de température (T$_{SEUIL}$) prédéterminé et dans lequel le courant d'excitation est asservi en utilisant une valeur inférieure nominale de consigne (L$_{0\_A}$) et une valeur supérieure nominale de consigne (L$_{1\_A}$) correspondant respectivement à un niveau bas de puissance et à un niveau haut de puissance de telle manière que le faisceau ait une puissance moyenne et un taux d'extinction optimaux pour la transmission des données ;

- un deuxième mode de fonctionnement lorsque la température dépasse le premier seuil de température et dans lequel le courant d'excitation est asservi sur une valeur inférieure réduite de consigne (L$_{0\_B}$ ; L$_{0\_T}$) et une valeur supérieure réduite de consigne (L$_{1\_B}$ ; L$_{1\_T}$) correspondant respectivement au niveau bas de puissance et au niveau haut de puissance de telle manière que le faisceau ait une puissance moyenne réduite en conservant un taux d'extinction acceptable pour la transmission des données.

2.    Procédé selon la revendication 1, dans lequel les valeurs réduites de consigne (L$_{0\_B}$, L$_{1\_B}$) sont déterminées par itérations successives lors d'une phase de calibration.

3.    Procédé selon la revendication 1, dans lequel les valeurs réduites (L$_{0\_B}$, L$_{1\_B}$) de consigne sont déterminées par calcul à partir des valeurs nominales de consigne (L$_{0\_A}$, L$_{1\_A}$).

4.    Procédé selon la revendication 1, dans lequel les valeurs réduites de consigne (L$_{0\_T}$, L$_{1\_T}$) sont déterminées par calcul lors du fonctionnement du dispositif d'émission et le calcul est une interpolation linéaire à partir des valeurs nominales de consigne (L$_{0\_A}$, L$_{1\_A}$), de la température déterminée (T$_{INT}$) et du premier seuil de température (T$_{SEUIL}$) de fonctionnement.

5.    Procédé selon la revendication 4, dans lequel l'interpolation linéaire est basée également sur des valeurs réduites théoriques de consigne (L$_{0\_B}$, L$_{1\_B}$), d'un second seuil de température (T$_{MAX}$) de fonctionnement de sorte que :

- la valeur inférieure réduite de consigne L$_{0\_T}$ utilisée pour l'asservissement est égale à

$$L_{0\_T} = L_{0\_A} + (T_{INT} - T_{SEUIL})\frac{L_{0\_B} - L_{0\_A}}{T_{MAX} - T_{SEUIL}}$$

- la valeur réduite de consigne supérieure L$_{1\_T}$ utilisée pour l'asservissement est égale à

$$L_{1\_T} = L_{1\_A} + (T_{INT} - T_{SEUIL})\frac{L_{1\_B} - L_{1\_A}}{T_{MAX} - T_{SEUIL}}$$

**6.** Procédé selon l'une quelconque des revendications 3 à 5, dans lequel la température ($T_{INT}$) au voisinage de la diode laser est déterminée selon une période prédéterminée et les valeurs réduites de consigne ($L_{0\_B}$, $L_{1\_B}$) sont calculées selon cette période.

**7.** Procédé selon la revendication 1, dans lequel les valeurs réduites de consigne sont déterminées expérimentalement à partir d'essais réalisés sur un échantillon de dispositifs d'émission de signaux en laissant converger le mode de fonctionnement dégradé de chaque dispositif d'émission vers une valeur supérieure réduite et une valeur inférieure réduite issues de convergence.

**8.** Procédé selon la revendication 7, dans lequel les valeurs réduites de consigne sont sensiblement égales à l'une des valeurs suivantes :

- une moyenne des valeurs supérieures réduites issues de convergence et une moyenne des valeurs inférieures réduites issues de convergence ;
- un minimum des valeurs supérieures réduites issues de convergence et un minimum des valeurs inférieures réduites issues de convergence ;
- un vingt-cinquième percentile des valeurs réduites supérieures issues de convergence et un au vingt-cinquième percentile des valeurs réduites inférieures issues de convergence.

**9.** Procédé selon l'une quelconque des revendications précédentes, dans lequel un troisième mode de fonctionnement est mis en oeuvre lorsque la température dépasse un deuxième seuil de température ($T_{MAX}$) prédéterminé.

**10.** Procédé selon la revendication 9, dans lequel la diode laser est pilotée pour avoir, dans le troisième mode de fonctionnement, un fonctionnement encore plus limité qu'en deuxième mode de fonctionnement.

**11.** Procédé selon l'une quelconque des revendications précédentes, dans lequel le procédé passe du mode de fonctionnement nominal au mode de fonctionnement dégradé quand la température au voisinage de la diode laser dépasse le premier seuil de température d'une valeur de dépassement prédéterminée et passe du mode de fonctionnement dégradé au mode de fonctionnement nominal quand la température au voisinage de la diode laser passe en dessous du premier seuil de température diminué d'une valeur de retour prédéterminée.

**12.** Dispositif d'émission d'un faisceau laser pour la transmission de données, comprenant un circuit électronique de traitement (1) pour créer un signal de courant représentatif de données à transmettre, un amplificateur (4) recevant en entrée le signal de courant et fournissant en sortie un courant d'excitation d'une diode laser (3), un circuit de pilotage (5) de l'amplificateur ayant une première entrée recevant des valeurs de consignes et une deuxième entrée reliée à une photodiode (7) qui est placée au voisinage de la diode laser (3) pour fournir au circuit de pilotage (5) un courant représentatif d'une puissance du faisceau laser, une sonde de température (8) reliée au circuit de traitement (1) pour fournir un signal de température au voisinage de la diode laser (3) ; le circuit de traitement (1) étant agencé pour mettre en œuvre un procédé de transmission comprenant l'étape de mesurer une température (TINT) pour mettre en oeuvre :

- un premier mode de fonctionnement jusqu'à un premier seuil de température ($T_{SEUIL}$) prédéterminé et dans lequel le courant d'excitation est asservi en utilisant une valeur inférieure nominale de consigne ($L_{0\_A}$) et une valeur supérieure nominale de consigne ($L_{1\_A}$) correspondant respectivement à un niveau bas de puissance et à un niveau haut de puissance de telle manière que le faisceau ait une puissance moyenne et un taux d'extinction optimaux pour la transmission des données ;
- un deuxième mode de fonctionnement lorsque la température dépasse le premier seuil de température et dans lequel le courant d'excitation est asservi sur une valeur inférieure réduite de consigne (L0_B ; $L_{0\_T}$) et une valeur supérieure réduite de consigne (L1_B ; $L_{1\_T}$) correspondant respectivement au niveau bas de puissance et au niveau haut de puissance de telle manière que le faisceau ait une puissance moyenne réduite en conservant un taux d'extinction acceptable pour la transmission des données.

**13.** Programme informatique comportant des instructions agencées pour mettre en oeuvre un procédé de transmission selon l'une quelconque des revendications 1 à 11.

**14.** Support de données contenant un programme informatique comportant des instructions agencées pour mettre en oeuvre un procédé de transmission selon l'une quelconque des revendications 1 à 11.

**Patentansprüche**

1. Datenübertragungsverfahren, umfassend den Schritt des Steuerns eines Anregungsstroms für eine Laserdiode einer Laserstrahl-Emissionsvorrichtung, indem der Anregungsstrom auf eine Leistung des Laserstrahls geregelt wird und indem der Anregungsstrom in Abhängigkeit der zu übertragenden Daten moduliert wird, um diese Daten mit Laserstrahlleistungsniveaus zu kodieren, **dadurch gekennzeichnet, dass** das Übertragungsverfahren den Schritt des Messens einer Temperatur ($T_{INT}$) in der Nähe der Laserdiode umfasst, um auszuführen:

   - einen ersten Betriebsmodus bis zu einem ersten vorbestimmten Temperaturschwellenwert ($T_{SEUIL}$), in dem der Anregungsstrom geregelt wird, indem ein nominaler unterer Sollwert ($L_{0\_A}$) und ein nominaler oberer Sollwert ($L_{1\_A}$), die einem unteren Leistungsniveau bzw. einem oberen Leistungsniveau entsprechen, derart verwendet werden, dass der Strahl eine durchschnittliche Leistung und ein Extinktionsverhältnis hat, die optimal für die Übertragung der Daten sind;
   - einen zweiten Betriebsmodus, wenn die Temperatur den ersten Temperaturschwellenwert überschreitet, in dem der Anregungsstrom auf einen reduzierten unteren Sollwert ($L_{0\_B}$; $L_{0\_T}$) und einen reduzierten oberen Sollwert ($L_{1\_B}$; $L_{1\_T}$) geregelt wird, die dem unteren Leistungsniveau bzw. dem oberen Leistungsniveau entsprechen, derart, dass der Strahl eine reduzierte durchschnittliche Leistung hat, während ein Extinktionsverhältnis, das für die Übertragung der Daten akzeptabel ist, beibehalten wird.

2. Verfahren nach Anspruch 1, bei dem die reduzierten Sollwerte ($L_{0\_B}$, $L_{1\_B}$) durch aufeinanderfolge Iterationen während einer Kalibrierungsphase bestimmt werden.

3. Verfahren nach Anspruch 1, bei dem die reduzierten Sollwerte ($L_{0\_B}$, $L_{1\_B}$) durch Berechnung auf der Basis der nominalen Sollwerte ($L_{0\_A}$, $L_{1\_A}$) bestimmt werden.

4. Verfahren nach Anspruch 1, bei dem die reduzierten Sollwerte ($L_{0\_T}$, $L_{1\_T}$) durch Berechnung während des Betriebs der Emissionsvorrichtung bestimmt werden und die Berechnung eine lineare Interpolation anhand von nominalen Sollwerten ($L_{0\_A}$, $L_{1\_A}$), der bestimmten Temperatur ($T_{INT}$) und des ersten Betriebstemperaturschwellenwerts ($T_{SEUIL}$) ist.

5. Verfahren nach Anspruch 4, bei dem die lineare Interpolation ebenso auf reduzierte theoretische Sollwerte ($L_{0\_B}$, $L_{1\_B}$) basiert wird, für einen zweiten Betriebstemperaturschwellenwert ($T_{MAX}$), derart dass:

   - der reduzierte untere Sollwert $L_{0\_T}$, der für die Regelung verwendet wird, gleich ist mit:

$$L_{0\_T} = L_{0\_A} + (T_{INT} - T_{SEUIL})\frac{L_{0\_B} - L_{0\_A}}{T_{MAX} - T_{SEUIL}}$$

   - der reduzierte obere Sollwert $L_{1\_T}$, der für die Regelung verwendet wird, gleich ist mit:

$$L_{1\_T} = L_{1\_A} + (T_{INT} - T_{SEUIL})\frac{L_{1\_B} - L_{1\_A}}{T_{MAX} - T_{SEUIL}}$$

6. Verfahren nach einem der Ansprüche 3 bis 5, bei dem die Temperatur ($T_{INT}$) in der Nähe der Laserdiode gemäß einer vorbestimmten Periode bestimmt wird und die reduzierten Sollwerte ($L_{0\_B}$, $L_{1\_B}$) gemäß dieser Periode berechnet werden.

7. Verfahren nach Anspruch 1, bei dem die reduzierten Sollwerte experimentell anhand von Versuchen bestimmt werden, die an einer Probe von Signalemissionsvorrichtungen ausgeführt werden, indem ermöglicht wird, dass der herabgesetzte Betriebsmodus jeder Emissionsvorrichtung auf einen reduzierten oberen Wert und einen reduzierten unteren Wert, die aus der Konvergenz resultieren, konvergiert.

8. Verfahren nach Anspruch 7, bei dem die reduzierten Sollwerte im Wesentlichen gleich einem der folgenden Werte sind:

   - ein Durchschnitt der reduzierten oberen Werte, die aus der Konvergenz resultieren, und ein Durchschnitt der reduzierten unteren Werte, die aus der Konvergenz resultieren;
- ein Mindestwert der reduzierten oberen Werte, die aus der Konvergenz resultieren, und ein Mindestwert der reduzierten unteren Werte, die aus der Konvergenz resultieren;
- ein fünfundzwanzigstes Perzentil der reduzierten oberen Werte, die aus der Konvergenz resultieren, und ein fünfundzwanzigstes Perzentil der reduzierten unteren Werte, die aus der Konvergenz resultieren.

**9.** Verfahren nach einem der vorhergehenden Ansprüche, bei dem ein dritter Betriebsmodus umgesetzt wird, wenn die Temperatur einen zweiten vorbestimmten Temperaturschwellenwert ($T_{MAX}$) überschreitet.

**10.** Verfahren nach Anspruch 9, bei dem die Laserdiode gesteuert wird, um in dem dritten Betriebsmodus einen noch begrenzteren Betrieb als im zweiten Betriebsmodus zu haben.

**11.** Verfahren nach einem der vorhergehenden Ansprüche, bei dem das Verfahren vom nominalen Betriebsmodus in den herabgesetzten Betriebsmodus übergeht, wenn die Temperatur in der Nähe der Laserdiode den ersten Temperaturschwellenwert um einen vorbestimmten Überschreitungswert überschreitet, und von dem herabgesetzten Betriebsmodus in den nominalen Betriebsmodus übergeht, wenn die Temperatur in der Nähe der Laserdiode unter den ersten Temperaturschwellenwert fällt, der um einen vorbestimmten Rückgabewert verringert ist.

**12.** Laserstrahl-Emissionsvorrichtung für die Übertragung von Daten, umfassend eine elektronische Verarbeitungsschaltung (1) zum Erzeugen eines Stromsignals, das repräsentativ für zu übertragenden Daten ist, einen Verstärker (4), der am Eingang das Stromsignal empfängt und am Ausgang einen Anregungsstrom zur Anregung einer Laserdiode (3) liefert, eine Steuerschaltung (5) zum Steuern des Verstärkers, die einen ersten Eingang hat, der Sollwerte empfängt, und einen zweiten Eingang, der mit einer Photodiode (7) verbunden ist, die in der Nähe der Laserdiode (3) platziert ist, um der Steuerschaltung (5) einen Strom zu liefern, der repräsentativ für eine Leistung des Laserstrahls ist, eine Temperatursonde (8), die mit der Verarbeitungsschaltung (1) verbunden ist, um ein Signal der Temperatur in der Nähe der Laserdiode (3) zu liefern; wobei die Verarbeitungsschaltung (1) ausgebildet ist, ein Übertragungsverfahren durchzuführen, das den Schritt des Messens einer Temperatur (TINT) umfasst, um umzusetzen:

- einen ersten Betriebsmodus bis zu einem ersten vorbestimmten Temperaturschwellenwert ($T_{SEUIL}$), in dem der Anregungsstrom geregelt wird, indem ein nominaler unterer Sollwert ($L_{0\_A}$) und ein nominaler oberer Sollwert ($L_{1\_A}$), die einem unteren Leistungsniveau bzw. einem oberen Leistungsniveau entsprechen, verwendet werden, derart, dass der Strahl eine durchschnittliche Leistung und ein Extinktionsverhältnis hat, die optimal für die Übertragung der Daten sind;
- einen zweiten Betriebsmodus, wenn die Temperatur den ersten Temperaturschwellenwert überschreitet, in dem der Anregungsstrom auf einen reduzierten unteren Sollwert ($L_{0\_B}$, $L_{0\_T}$) und einen reduzierten oberen Sollwert ($L_{1\_B}$; $L_{1\_T}$) geregelt wird, die dem unteren Leistungsniveau bzw. dem oberen Leistungsniveau entsprechen, derart, dass der Strahl eine reduzierte durchschnittliche Leistung hat, während ein Extinktionsverhältnis, das für die Übertragung der Daten akzeptabel ist, beibehalten wird.

**13.** Computerprogramm, umfassend Anweisungen, die ausgebildet sind, ein Übertragungsverfahren nach einem der Ansprüche 1 bis 11 durchzuführen.

**14.** Datenträger, der ein Computerprogramm enthält, das Anweisungen umfasst, die ausgebildet sind, ein Übertragungsverfahren nach einem der Ansprüche 1 bis 11 durchzuführen.

**Claims**

**1.** A data transmission method including the step of controlling excitation current for a laser diode of a laser beam emitter device by servocontrolling the excitation current on laser beam power and by modulating the excitation current as a function of the data for transmission in order to encode the data with laser beam power levels, the method being **characterized in that** it includes the step of measuring a temperature ($T_{INT}$) in the vicinity of the laser diode in order to perform:

· a first mode of operation up to a first predetermined temperature threshold ($T_{SEUIL}$), in which mode the excitation current is servocontrolled by using a nominal low setpoint value ($L_{0\_A}$) and a nominal high setpoint value ($L_{1\_A}$) corresponding respectively to a low power level and to a high power level in such a manner that the beam has an average power and an extinction ratio that are optimum for transmitting the data;

· a second mode of operation when the temperature exceeds the first temperature threshold, in which mode the excitation current is servocontrolled on a reduced low setpoint value ($L_{0\_B}$; $L_{0\_T}$) and on a reduced high setpoint value ($L_{1\_B}$; $L_{1\_T}$) corresponding respectively to a low power level and to a high power level in such a manner that the beam has a reduced average power level while conserving an extinction ratio that is acceptable for transmitting data.

**2.** A method according to claim 1, wherein the reduced setpoint values ($L_{0\_B}$, $L_{1\_B}$) are determined by successive iterations during a calibration stage.

**3.** A method according to claim 1, wherein the reduced setpoint values ($L_{0\_B}$, $L_{1\_B}$) are determined by calculation on the basis of the nominal setpoint values ($L_{0\_A}$, $L_{1\_A}$).

**4.** A method according to claim 1, wherein the reduced setpoint values ($L_{0\_T}$, $L_{1\_T}$) are determined by calculation during operation of the emitter device and the calculation is a linear interpolation on the basis of the nominal setpoint values ($L_{0\_A}$, $L_{1\_A}$), of the determined temperature ($T_{INT}$) and of the first operating temperature threshold ($T_{SEUIL}$).

**5.** A method according to claim 4, wherein the linear interpolation is also based on reduced theoretical setpoint values ($L_{0\_B}$, $L_{1\_B}$), for a second operating temperature threshold ($T_{MAX}$) such that:

· the reduced low setpoint value ($L_{0\_T}$) that is used for servocontrol is equal to

$$L_{0\_T} = L_{0\_A} + (T_{INT} - T_{SEUIL}) \frac{L_{0\_B} - L_{0\_A}}{T_{MAX} - T_{SEUIL}}$$

· the reduced high setpoint value ($L_{1\_T}$) that is used for servocontrol is equal to

$$L_{1\_T} = L_{1\_A} + (T_{INT} - T_{SEUIL}) \frac{L_{1\_B} - L_{1\_A}}{T_{MAX} - T_{SEUIL}}$$

**6.** A method according to any one of claims 3 to 5, wherein the temperature ($T_{INT}$) in the vicinity of the laser diode is determined with a predetermined period and the reduced setpoint values ($L_{0\_B}$ and $L_{1\_B}$) are calculated for that period.

**7.** A method according to claim 1, wherein the reduced setpoint values are determined experimentally from tests performed on a sample of signal emitter devices by allowing the degraded mode of operation of each emitter device to converge on a reduced high value and on a reduced low value that result from the convergence.

**8.** A method according to claim 7, wherein the reduced setpoint values are substantially equal to one of the following values:

· the average of the reduced low values derived from convergence and the average of the reduced high values derived from convergence;
· the minimum of the reduced low values derived from convergence and the minimum of the reduced high values derived from convergence;
· the twenty-fifth percentile of the reduced high values derived from convergence and the twenty-fifth percentile of the reduced low values derived from convergence.

**9.** A method according to any preceding claim, wherein a third mode of operation is performed when the temperature exceeds a second predetermined temperature threshold ($T_{MAX}$).

**10.** A method according to claim 9, wherein in the third mode of operation, the laser diode is controlled to operate in a manner that is even more limited than in the second mode of operation.

**11.** A method according to any preceding claim, wherein the method switches from the nominal mode of operation to the degraded mode of operation when the temperature in the vicinity of the laser diode exceeds the first temperature threshold by a predetermined excess value, and switches from the degraded mode of operation to the nominal mode of operation when the temperature in the vicinity of the laser diode passes below the first temperature threshold minus a predetermined return value.

12. A laser beam emitter device for emitting a laser beam to transmit data, the device comprising an electronic processor circuit (1) for creating a current signal representative of data to be transmitted, an amplifier (4) receiving the current signal as input and outputting excitation current for a laser diode (3), an amplifier control circuit (5) having a first input receiving setpoint values and a second input connected to a photodiode (7) that is placed in the vicinity of the laser diode (3) to supply the control circuit (5) with current representative of the power of the laser beam, and a temperature probe (8) connected to the processor circuit (1) to provide a signal representative of the temperature in the vicinity of the laser diode (3); the processor circuit (1) being arranged to perform a transmission method including the step of measuring a temperature ($T_{INT}$) in order to perform:

· a first mode of operation up to a first predetermined temperature threshold ($T_{SEUIL}$), in which mode the excitation current is servocontrolled by using a nominal low setpoint value ($L_{0\_A}$) and a nominal high setpoint value ($L_{1\_A}$) corresponding respectively to a low power level and to a high power level in such a manner that the beam has an average power and an extinction ratio that are optimum for transmitting the data;
· a second mode of operation when the temperature exceeds the first temperature threshold, in which mode the excitation current is servocontrolled on a reduced low setpoint value ($L_{0\_B}$; $L_{0\_T}$) and on a reduced high setpoint value ($L_{1\_B}$; $L_{1\_T}$) corresponding respectively to a low power level and to a high power level in such a manner that the beam has a reduced average power level while conserving an extinction ratio that is acceptable for transmitting data.

13. A computer program including instructions arranged to perform a transmission method according to any one of claims 1 to 11.

14. A data medium containing a computer program including instructions arranged to perform a transmission method according to any one of claims 1 to 11.

Fig. 1

Fig. 2

Fig. 3

Fig. 4

Fig. 5

Fig. 6

Fig. 7

TIMER
5s

Mesure $T_{INT}$

$T_{INT} > T_{SEUIL}$ ?

Non | Oui

$0x9A = L_{1\_A}$
$0x9B = L_{0\_A}$

Calcul
$L_{0\_T}$ & $L_{1\_T}$

$0x9A = L_{1\_T}$
$0x9B = L_{0\_T}$

Fin

## RÉFÉRENCES CITÉES DANS LA DESCRIPTION

**Documents brevets cités dans la description**

- EP 3276304 A1
- CN 210922619 U